## Europäisches Patentamt

## European Patent Office

## Office européen des brevets

(11) Publication number: **0 100 503**
**B1**

# EUROPEAN PATENT SPECIFICATION

(45) Date of publication of patent specification: **12.12.90**

(51) Int. Cl.⁵: **H 03 H 9/64,** H 03 H 9/145

(21) Application number: **83107258.2**

(22) Date of filing: **23.07.83**

(54) High frequency narrow-band pass multi-mode filter.

(30) Priority: **26.07.82 JP 130140/83**

(43) Date of publication of application:
**15.02.84 Bulletin 84/07**

(45) Publication of the grant of the patent:
**12.12.90 Bulletin 90/50**

(84) Designated Contracting States:
**DE GB**

(56) References cited:
**JP-A-58 012 418**
**US-A-4 060 777**

**PATENT ABSTRACTS OF JAPAN, vol. 8, no. 103
(E-244)1540r, 15th May 1984 & JP-A-59-21116**

**PATENT ABSTRACTS OF JAPAN, vol. 8, no. 103
(E-244)1540r, 15th May 1984 & JP-A-59-21114**

**PATENT ABSTRACTS OF JAPAN, vol. 8, no. 103
(E-244)1540r, 15th May 1984 & JP-A-59-21115**

(73) Proprietor: **TOYO COMMUNICATION
EQUIPMENT CO.,LTD.
753, Koyato, Samukawa-machi
Koza-gun Kanagawa 253-01 (JP)**

(72) Inventor: **Nakazawa, Yuzo Toyo Comm.
Equipment Co. Ltd.
753 Koyato Samukawa-machi
Kouza-gun Kanagawa-ken (JP)**
Inventor: **Ono, Kazuo Toyo Communication
Equipment Co. Ltd.
753 Koyato Samukawa-machi
Kouza-gun Kanagawa-ken (JP)**
Inventor: **Tanaka, Masaki Toyo Comm.
Equipment Co. Ltd.
753 Koyato Samukawa-machi
Kouza-gun Kanagawa-ken (JP)**
Inventor: **Morita, Takao Toyo Comm.
Equipment Co. Ltd.
753 Koyato Samukawa-machi
Kouza-gun Kanagawa-ken (JP)**
Inventor: **Kurosaki, Takefumi Toyo Comm.
Equipment Co. Ltd.
753 Koyato Samukawa-machi
Kouza-gun Kanagawa-ken (JP)**

(74) Representative: **Selting, Günther, Dipl.-Ing. et al
Deichmannhaus am Hauptbahnhof
D-5000 Köln 1 (DE)**

# Description

## 1. Field of the Invention

The present invention relates a high frequency narrow-band multi-mode filter which comprises surface acoustic wave (hereinafter, referred to as SAW) resonators or surface skimming bulk wave (hereinafter, referred to as SSBW) resonators and which exhibits a narrow band pass characteristic of between several tens MHz and 1GHz.

Band pass filters for frequencies above 50MHz include an LC filter, a spiral filter, a SAW filter or a band pass filter where resonance elements or inductors in a basic circuit are replaced with SAW resonators.

However, such band pass filters have the following defects.

In the case of the LC and spiral filters, they have both a low Q value. In particular, the spiral filter is large in size. In the case of the SAW filter, on the other hand, it has a relatively wide band and a large insertion loss. In addition, there occur ripples in its pass band due to triple transit echo (TTE).

Finally, in the case of the band pass filter of the type where resonance elements are replaced with SAW resonators, this type of filter is the same as a conventional crystal filter in principle. However, when it is to be operated for high frequencies beyond 100 MHz, it has been highly difficult to set or fix the resonance frequencies of the elements and differences therebetween with high accuracy.

US—PS 4,060,777 discloses a resonator and resonator type wave filter formed by a piezoelectric body on which acoustic surface waves are guided and reflected and in which mode coupling in a direction transverse to the surface wave propagation is utilized. The transverse modes are controlled so as to provide improved response characteristics by minimizing suppressing and/or otherwise controlling unwanted modes of vibration in the body.

It is an object of the present invention to provide a narrow band pass filter with a high Q value and stability which can be suitably used for a high frequency range between several tens MHz and 1GHz and which can be manufactured highly compactedly and inexpensively.

The problem is solved by a high frequency narrow-band double-mode filter comprising at least two resonators arranged adjacent to each other, acting as input and output transducers, each of said resonators having the same resonance frequency and comprising a pair of combtype interdigital transducer electrode arrays, the electrodes of said arrays being interleaved with each other, wherein

a common bus bar is provided between and connected to adjacent two of said resonators,

said two resonators being arranged in directions perpendicular to a propagation direction of waves excited by said resonators and in close proximity to each other on a piezoelectric substrate so that acoustic coupling occurs between said adjacent two resonators, thereby causing multiple resonance frequencies of different vibrating modes,

the overlap of the electrodes of said respective pairs of electrode arrays of said adjacent two resonators defining respective acoustic apertures of width w and the distance between said first and second acoustic apertures defining a gap g,

said filter utilizing said multiple resonance frequencies of different vibration modes generated by the acoustic coupling, wherein said width w and gap g satisfies the relation $w \leq 20\lambda$ and $g \leq 6\ \lambda$, where $\lambda$ is the wavelength of a wave corresponding to said same resonance frequency of each of said resonators.

According to a first feature of the present invention, since the band width of the filter can be designed with a considerable flexibility, an intermediate stage filter and associated local oscillator in a mobile radio equipment which tends to operate on higher frequencies with crowded frequency allocation can be replaced with the filter of the present invention, whereby the equipment can be effectively made compact, light in weight and inexpensive.

According to a second feature of the invention, a common bus bar for SAW or SSBW resonators used in a multi-mode filter is made very narrow and correspondingly the loss of the filter is increased, but the employment of such a structure as will be disclosed later for the bus bar enables the minization of the ohmic loss of the bus bar and thus of the filter loss and also enables the easy connection of the bar to the lead terminals of resonator electrodes.

According to one aspect of the present invention, there is provided a high frequency narrow-band pass multi-mode filter wherein SAW or SSBW resonators are closely disposed to each other on a single piezo-electric substrate to generate different vibration modes of different resonance frequencies, conditions that the resonators are acoustically coupled to each other to cause said vibration modes, are experimentally found, and said conditions are satisfied by said filter.

According to another aspect of the invention, there is provided a so-called reflector type multi-mode filter wherein, in order to reduce the ohmic loss of the very narrow common bus bar, the number of strip pairs of electrode in both interdigital transducers (hereinafter referred to as IDT) is minimized and instead reflectors are provided on the both sides of said IDTs to compensate for the reduction of its Q value. A part of the bus bar for the IDT electrodes is formed integral with some or all of gratings of the reflectors, whereby the connecting positions of the grating electrodes with respect to lead terminals can be positioned with a high freedom.

According to a further aspect of the invention, there is provided a reflector type multi-mode filter based on SAW or SSBW resonator, wherein the common bus bar is extended across gratings of the reflectors so that the width of the bus bar is increased gradually toward both edges of the piezo-electric substrate while the bus bar is connected or not connected to the reflector gratings.

According to yet another aspect of the invention, there is provided a reflector type multi-mode filter based on SAW or SSBW resonator, wherein electrode lead patterns are provided in place between the IDTs and reflectors, one end of said lead pattern is connected to the common bus bar and the other end is extended to a peripheral edge of the piezo-electric substrate.

According to a still further aspect of the invention, there is provided a reflector type multi-mode filter based on SAW or SSBW resonators, wherein the common bus bar is extended across grooves of the reflectors up to both edges of the substrate while not connected to the grooves, and the width of the bus bar is increased gradually toward both edges of the piezo-electric substrate.

The above and other objects and features of the present invention will become clear from the following description with reference to the accompanying drawings, in which:

Fig. 1(a) to (c) show a basic electrode structure of a SAW double mode filter according to the invention and two vibration mode patterns generated by the same filter, respectively;

Fig. 2 is a diagram explaining the distribution of vibration energy (displacement) caused by the SAW generated in the adjacent two resonators;

Fig. 3(a) and (b) are diagrams explaining a relationship between the two vibration modes shown in Fig. 1 and width of an acoustic aperture (overlapped length of IDT fingers) w and gap between acoustic apertures of both resonators g of the resonators;

Fig. 4 is an equivalent circuit of the SAW double mode filter;

Fig. 5 shows a relation between an attenuation characteristics of the filter and resonance frequencies of the two vibration modes;

Figs. 6 and 7 are experimental data showing acoustic coupling intensity affected by parameters g and w when the width w is fixed and when the gap g is fixed, respectively;

Fig. 8 shows experimental data when the both data of Figs. 6 and 7 are combined;

Fig. 9 is a table showing experimental data as to whether or not the acoustic coupling has actually occurred when the parameters g and w are both varied; and

Figs. 10 to 17 are different embodiments of the filter embodying the present invention.

The present invention will be detailed on the basis of a theory of estimating parameters determining the acoustic coupling intensity between resonators and of the results of experiments conducted in accordance with the theory.

Several types of filters based on the acoustic coupling between SAW resonators are already proposed, but they are still at a conceptional stage and there does not actually exist, so far, such a filter that the acoustic coupling is provided on the basis of particular conditions on the electrode structure of the SAW resonators.

The inventors, in examining the conditions in which the acoustic coupling is occurred, have estimated the conditions as follows on the basis of the study results of conventional SAW and SSBW resonators.

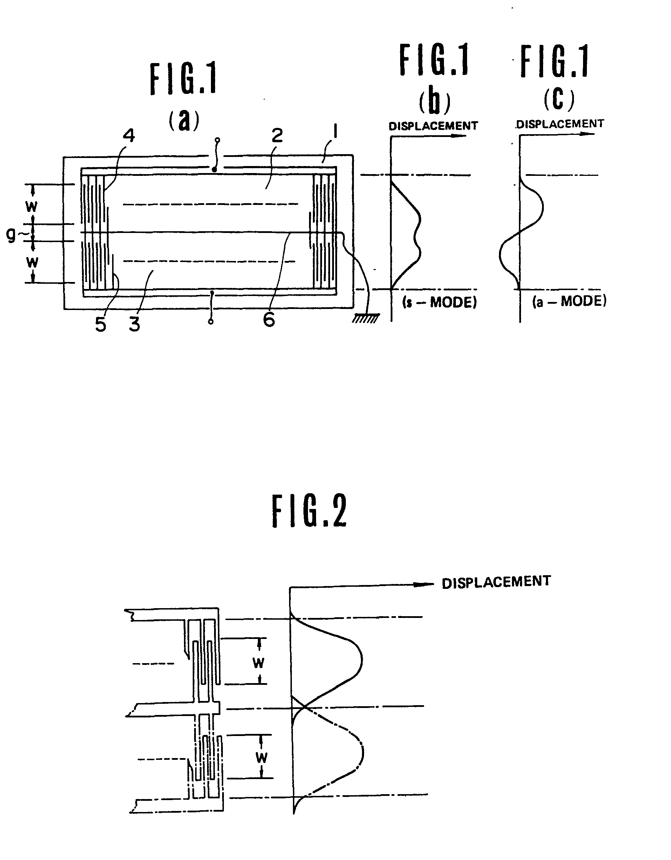

Explanation will be made in the case where two SAW resonators are used, for the brevity of the explanation. That is, as shown in Fig. 1(a) to (c), two SAW resonators 2 and 3 are disposed on a piezo-electric substrate 1 in a parallel and closely opposed relation so that, when the resonators 2 and 3 are excited and the resultant SAWs are acoustically coupled to each other, the resonators 2 and 3 generate such two vibration modes as shown in Fig. 1(b) and (c), that is, symmetrical mode (s-mode) and anti-symmetrical mode (a-mode).

Now, consideration will be made as to such acoustic coupling conditions. Fig. 2 shows a vibration mode of a single SAW resonator. It is known that the vibration energy leaks beyond the acoustic aperture of the resonators as illustrated in Fig. 2 and the vibration mode depends on the width w, and thus it will be obvious that the width w is one of the factors determining the acoustic coupling intensity between the both resonators.

On the other hand, the fact that there exists the acoustic coupling between the adjacent resonators means that the vibration energy of one of the both resonators is affected by that of the other. Therefore, it is obviously necessary to dispose the both resonators in a sufficiently closed relation therebetween.

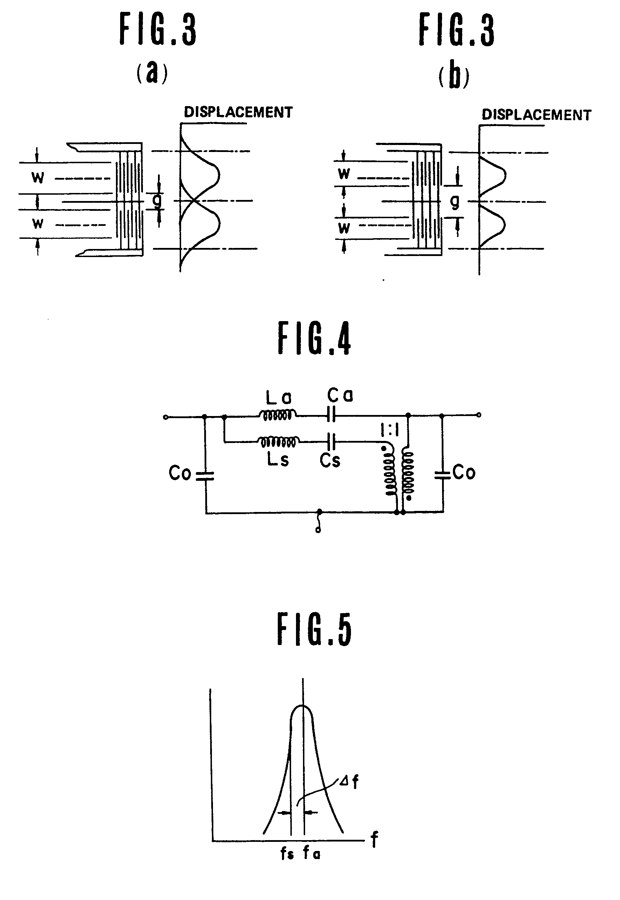

Referring now to Figs. 3(a) and 3(b), there is qualitatively illustrated a relationship between the vibration mode and the acoustic coupling intensity for the larger and smaller values of g. It is clear from the drawing that the gap g is a parameter indicative of the adjacency between the both resonators. More specifically, it is considered that, so long as the value g is greater than a certain value, any acoustic coupling will not take place between the resonators 2 and 3 as exaggeratedly depicted in Fig. 3(b), even if the other parameters are in their coupling generation ranges.

From the above consideration, the inventors have concluded that the width w and the gap g will determine the acoustic coupling conditions.

In other words, when the parameter w and g are selected to be below certain values respectively, the acoustic coupling will take place between the both resonators 2 and 3 and the coupling intensity will depend largely upon the parameters w and g. Therefore, when the two SAW resonators are designed so that the two parameters satisfies the above conditions, acoustic coupling will take place, whereby two modes (s-mode and a-mode) of vibration will generate, as has been mentioned above.

The double mode SAW filter arranged as described above can be expressed with such an equivalent circuit as shown in Fig. 4 wherein the resonance frequencies $f_a$ and $f_s$ of branch circuits respectively including elements $L_a$ and $C_a$ and elements $L_s$ and $C_s$ correspond to anti-symmetrical, and symmetrical vibration mode resonance frequencies respectively, and a relation $f_a > f_s$ is always satisfied, providing a frequency differences $\triangle f = f_a - f_s$. Further, two times the frequency difference $\triangle f$, i.e., $2 \triangle f$ is equal nearly to the band width of the filter. Fig. 5 shows an attenuation characteristic and a relation between the frequencies $f_a$ and $f_s$.

Description will be made on the basis of the above logical consideration and several experiments above how the frequency difference $\triangle f$ varies with the parameters w and g.

First, an ST cut quartz crystal substrate having a cut angle 37° and a good frequency-temperature characteristic has been employed as the piezoelectric substrate of a filter to be used in the experiments and aluminum electrodes have been formed on a polished main surface of the substrate by the photolithography process. The film thicknesses of the electrodes have been selected to be 1.5, 2.2 and 3.0% of the wavelength $\lambda$ of a surface wave to be excited and the electrode fingers of the upper and lower resonators have been arranged to be the same in phase (that is, to be symmetrical with respect to the common bus bar 6 as shown in Fig. 1). Of course, the electrode fingers may be arranged not to be symmetrical.

The number of such electrode finger pairs of IDT has been selected to be 400, 500, 600 and 800 and a center frequency has been selected to be 280MHz.

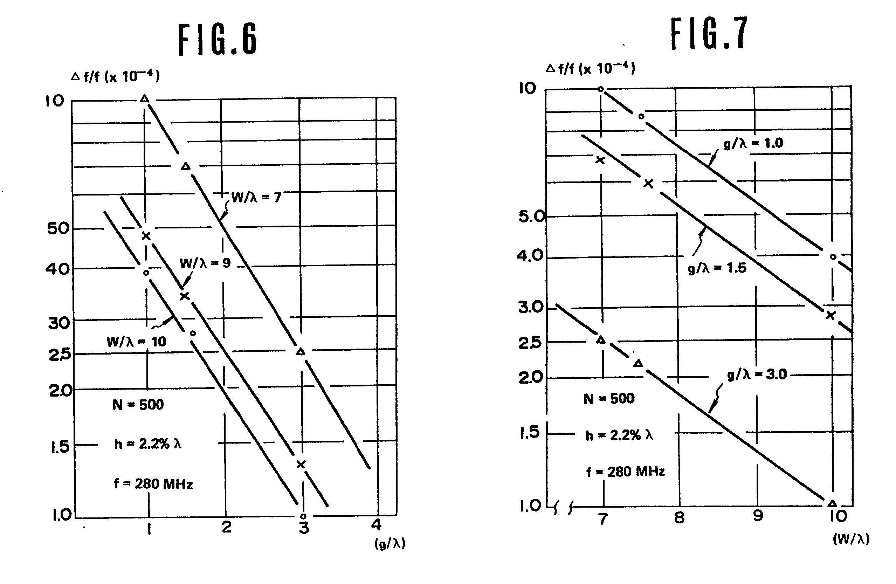

Under the above conditions, experiments have been conducted for several different values of the parameters w and g. The results are as shown in Figs. 6 and 7.

More specifically, Fig. 6 is graphs showing an acoustic coupling intensity when the parameter w is fixed and the parameter g is varied, while Fig. 7 is graphs showing an acoustic coupling intensity when the parameter g is fixed and the parameter w is varied.

It has been found from Figs. 6 and 7 that the acoustic coupling between the both resonators is more strongly affected by the gap g of the the common bus bar than by the width w.

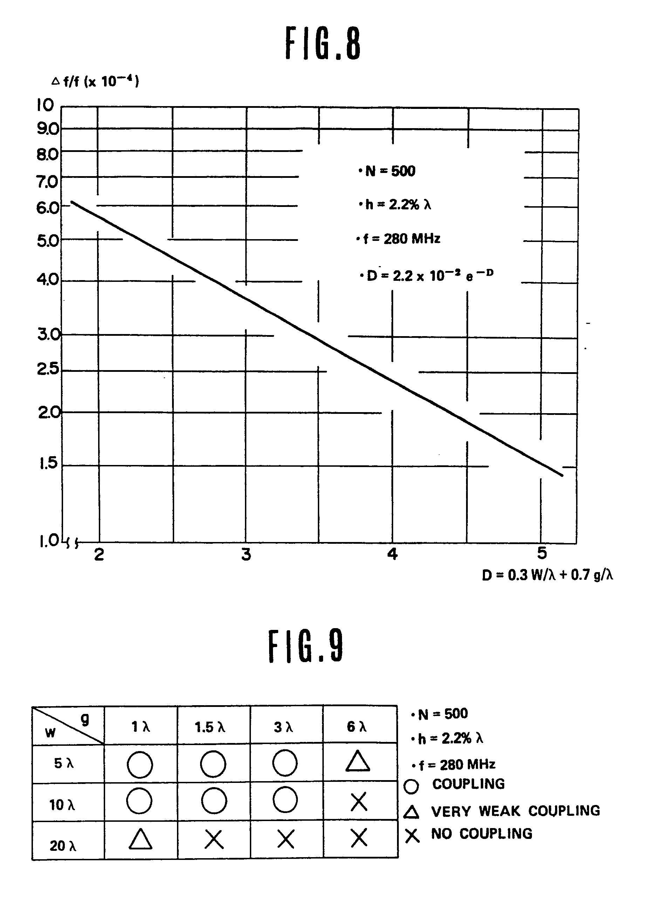

When a new parameter $D = 0.3(w/\lambda) + 0.7(g/\lambda)$ indicative of the intensity of the acoustic coupling affected by the both parameters w and g is assumed, an experimental equation $\triangle f/f = K \cdot exp^{(-D)}$ can be obtained, where (f ÷ $f_a$ is the center frequency of the filter, $\triangle f$ is a frequency difference between the a-mode and s-mode, and K is a proportional constant and was determined to be $2.2 \times 10^{-2}$ in the above experiment. The experimental results are given in Fig. 8. It will be easily understood that, at the time of designing an actual filter, the values w and g are properly selected to meet the specifications of the filter.

Examination has been made in the above experiment as to the case where the electrode thickness h and the number of electrode finger pair N are varied in addition to the parameters w and g, and it has been found that a curve given in Fig. 8 is slightly shifted parallelly and variations in the both parameters will not provide any substantially significant effect on the acoustic coupling. Therefore, the detailed explanation thereabout is omitted, and it will be sufficient to say that the proportional constant K is varied slightly in response to the variation of the parameters h and/ or N, and that, for example, when the electrode thickness was between 0.5% and 4% with respect to the wavelength of the surface wave and the number was between 400 and 800, the constant K was varied between $1.5 \times 10^{-2}$ and $3 \times 10^{-2}$.

Next, examination was made as to the limit values of the parameters w and g and the results as shown by a table in Fig. 9 were obtained.

That is, it has been found that the limits of the parameters g and w are about 6$\lambda$ and 20$\lambda$ respectively when the presence or absence of the acoustic coupling is decided on the basis of an impedance characteristic of the filter in which values of w and g were varied.

In an actual filter design, when the parameter w is below 5$\lambda$, the Q value of the resonator becomes very low, which may make it difficult to put the filter to practical use. On the other hand, when the parameter w is close to 20$\lambda$, the vibration energy is trapped in the acoustic aperture substantially. Accordingly, even if the value g is selected to be small to its manufacturable limit level, the acoustic coupling becomes very weak, which results in a filter having a very narrow pass band width and thus in failure of its practical use.

As a result, the inventors have concluded from the above experimental results that the value w must be selected to be below 20 and the value g must be selected to below 6$\lambda$, desirably below 3.

In other words, the band width of such a type of filter depends on the parameter $D = (\approx 0.3w/\lambda) + 0.7(g/\lambda)$, and it is clear that the parameter g has an effect on the acoustic coupling about 2.5 times as strongly as the parameter w. Thus, it is found the value g must be set to be extraordinally small when compared with that in the prior art in order that the filter can exhibit its filtering function.

For example, it is assumed that a narrow band pass filter has a specific band width of between $10^{-4}$ and $10^{-3}$ and thus, if the filter has a center frequency of 280MHz and a band width of 280KHz and the parameter w is set to be 10$\lambda$, then the parameter g has a value of about 10 $\mu$m and the width of the common bus bar 6 is 5 $\mu$m at the largest.

This bus bar width 5 $\mu$m corresponds to a little less than two times the width (about 2.8 $\mu$m) of an IDT electrode finger in a resonator and thus, this means that the common bus bar must be made very narrow, unlike a conventional bus bar in the prior art in which it has been unnecessary to take the ohmic loss of the bus bar into consideration. Since such a narrow bus bar forms an essential requirement to function the SAW double mode filter as a filter, it is necessary to minimize the ohmic loss of the common bus bar to prevent the reduction of the Q value, as will be described later.

Attention will be directed again to the above-mentioned experimental conditions. In the above experiment, the ST cut quartz crystal substrate having a cut angle of 37° has been used as the piezo-electric substrate. The reason why the cut angle of 37° has been chosen is, as well known, for compensating a shift in the peak temperature of the quarts crystal frequency-temperature characteristic caused by mass loading of electrode.

However, since the electrode film thickness will not have a significant effect on the acoustic coupling as has been mentioned already, a quarts crystal substrate having a cut angle of between about 30° and about 43° in the rotated Y-cut system can be used. Incidentally, the cut angle of 30° is an angle for shifting the peak temperature of quartz crystal into a room temperature when the aluminum electrode thickness is 5-6% with respect to the wavelength of SAW (spurious will be increased if the electrode thickness exceeds 5-6%), while the cut angle of 43° is an angle at which the peak temperature of the non-electrode ST cut quartz coincides with a room temperature.

When the cut angle of the quarts crystal substrate is used in the above range, the substrate exhibits the most favorable frequency-temperature characteristic, but in manufacturing a filter, the cut angle is not limited to the above range and other cut angles may be employed according to the specifications of the filter.

Although the above explanation has been made about the multiple mode filter based on SAW resonator, the present invention can be similarly applied to a multiple mode filter based on SSBW resonator.

As well known, SSBW is a wave which propagates immediately below the surface of a piezo-electric substrate and is generated when a rotated Y cut quarts crystal substrate has a cut angle of minus 50° or so and the IDT electrode is attached on the main surface of the substrate to propagate a wave in a Z′ direction.

The pattern of vibration energy trapped in the ITD electrode of the SSBW filter, especially, the energy distribution in the wave propagating direction is exactly the same as that of the SAW resonator.

Therefore, it will be easily appreciated that, if the SSBW resonators are positioned to meet the requirements obtained from the above experiment, the similar acoustic coupling can be obtained.

Finally, explanation will be directed to problems involved when the SAW or SSBW double mode filter is to be put to practical use in accordance with the present invention.

In the above explanation, the resonator in the filter of the present invention has been of the so-called comb or multiple pair electrode type where multiple pairs of IDT electrodes are employed to obtain a high Q value of the resonator but for the same purpose, the resonator may be of a so-called reflector type where reflectors are disposed on the both sides of IDT electrode.

Since this reflector type resonator can have a sufficiently high Q value even if the IDT comprises a relatively small number of electrode fingers pairs, the common bus bar of IDT can be made short and correspondingly the ohmic loss of the bus bar can be decreased and in addition, the characteristic impedance can be designed freely. For these reasons, it is considered, from the view of arranging a filter according to the present invention, that the employment of the reflector type resonator is more preferable than the multiple pair electrode type resonator.

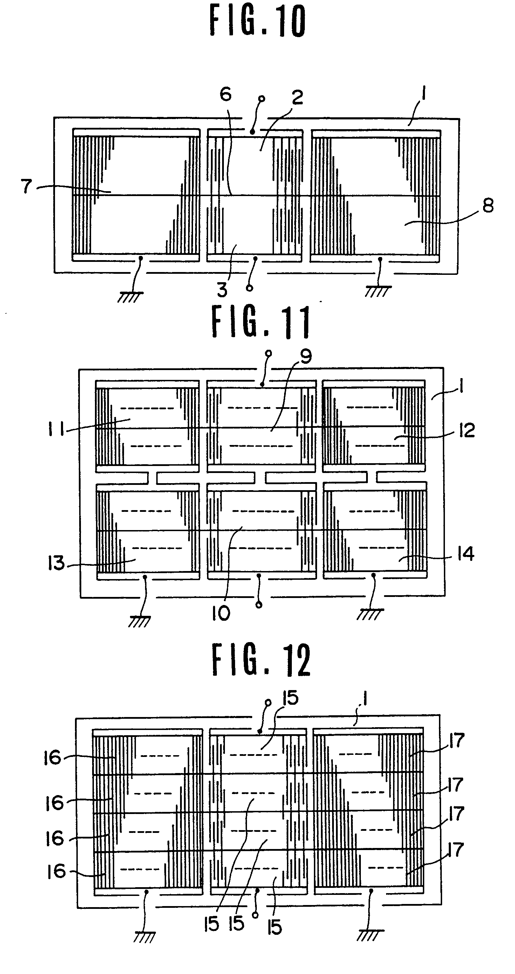

More specifically, even in the case when reflectors 7 and 8 are disposed on the both sides of the IDTs 2 and 3 and the number of IDT electrode fingers is set to be approximately 20% of that of the multiple pair electrode type resonator as shown in Fig. 10, the reflector type resonator can have a Q value equal to or higher than that of the multiple pair electrode type resonator the number of whose electrode finger corresponds to a total number of the electrode fingers of the IDTs 2 and 3 and the electrode fingers of the reflectors 7 and 8.

In this connection, if the pitch of the grating of the reflectors 7 and 8 is designed to be slightly wider, (a several hundredth) than that of the IDT, the excited wave can be efficiently reflected. When a filter is constructed (With the reflector type filter reflectors, as mentioned above, the width of the common bus bar 6 must be about 5 μm at the largest as mentioned earlier and thus it is practically, impossible to bond leading wires on such a narrow bus bar. For this reason, the common bus bar 6 is formed integral with the reflectors 7 and 8 and the IDTs are grounded through the bus bar of the reflectors 7 and 8.

Such an arrangement enables the reduction of the ohmic loss of the common bus bar 6, whereby the filter loss can be reduced.

Although the above explanation has been made as to the basic arrangement example where the present invention is applied to a practical filter, the invention can be modified and developed as follows on the basis of the basic arrangement.

Fig. 11 shows the electrode pattern of a multi-sectioned double mode filter wherein two of the above-mentioned double mode filter are electrically connected in a tandem manner. More specifically, in the drawing, reflectors 11, 12, 13, and 14 are formed on the both sides of respective double mode resonator filters 9 and 10 on the single substrate 1, the IDT electrodes and reflectors are formed in one shot of photolithography.

Referring further to Fig. 12, there is shown yet another embodiment wherein plural pairs of reflectors 16 and 17 are positioned on the both sides of respective IDTs 15 in a multi-staged and adjacent relation.

The filter arranged as above can provide a high-order shape factor and highly guaranteed attenuations due to the resonance frequency of each mode generated by the acoustic coupling of the vibration energy, and can also provide odd-order shape factor. On the other hand, the above double mode filter or the filter comprising multiple stages of said double mode filters can provide only an even-order shape factor.

The above-mentioned filters can be designed with the exact design method in which each resonator is substituted into respective equivalent constants through Chebyshev characteristic with attenuation peaks.

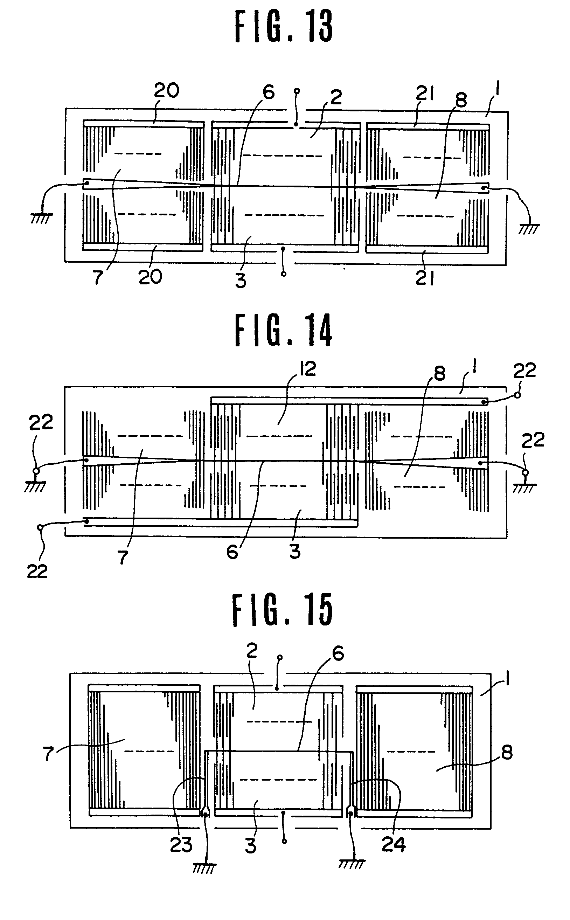

There is shown in Fig. 13 a still further embodiment intended to reduce the above-mentioned ohmic loss of the common bus bar, wherein the common bus bar 6 for a relatively small number of electrode finger pairs in the IDTs 2 and 3 is not connected to the gratings of the reflectors 7 and 8 provided on the both sides of said IDTs 2 and 3 and is extended across the gratings, the width of the common bus bar being gradually increased as the bus bar enters into the reflectors, earthing wires being bonded to the widest ends of the bus bar around the edges of the substrate 1, said wires being connected to ground.

Since length of the narrowest portion of the common bus bar 6 corresponds to only that of the IDTs 2 and 3 and the other portions of the bus bar are made wide, the ohmic loss of the bus bar can be minimized and correspondingly the filter loss can be minimized.

In this case, with respect to the shape of the gratings in each reflector 7 or 8, the length of strips of the gratings is gradually decreased toward outer side of the reflector. Such a grating structure might have adverse effect on the propagation and reflection of the excited SAW and thus on the characteristic of the filter, but it has been confirmed from our experiments that such a structure will have no effect on the filter characteristics.

This is presumably because the reflection of the SAW propagating toward the reflectors 7 and 8 becomes weak gradually as the wave goes near to outer side of the reflectors so that the decrease in strip length of the grating corresponds substantially to the energy attenuation of the SAW.

With respect to the shape of the common bus bar 6 across the reflector gratings, it has been confirmed that a triangle or a part of an ellipse having a major axis corresponding to the width of the electrodes including the reflector electrodes in the SAW-wave propagating direction and a minor axis corresponding to the width of the electrodes perpendicular to the SAW direction can be employed as the bus bar shape, while the filter characteristic is substantially the same as that obtained in the above embodiments.

Fig. 14 shows a modification of the embodiment of Fig. 13, providing the same effect as the embodiment of Fig. 13. In fig. 14, bus bars 20 and 21 on one sides of the gratings in the reflectors 7 and 8 in Fig. 13 are removed and the above-mentioned tapered common bus bar 6 is extended across the gratings of the reflectors 7 and 8 and connected to the gratings.

For example, if the common bus bar of the electrodes of the IDTs 2 and 3 is symmetrically extended to the one ends of the reflectors on the piezo-electric substrate 1, then the positions of lead terminals 22, passing through a package (not shown), in a air-tight and electrically insulated manner are rotation-symmetrical with respect to the center of the substrate 1, and thus the package can be mounted on a printed circuit board with a high freedom of its mounting direction. Further, since the hot terminals of the electrodes of the IDTs 2 and 3 are separated by the maximum distance, this enables the minimization of the effect on the filter characteristic due to feed through signal.

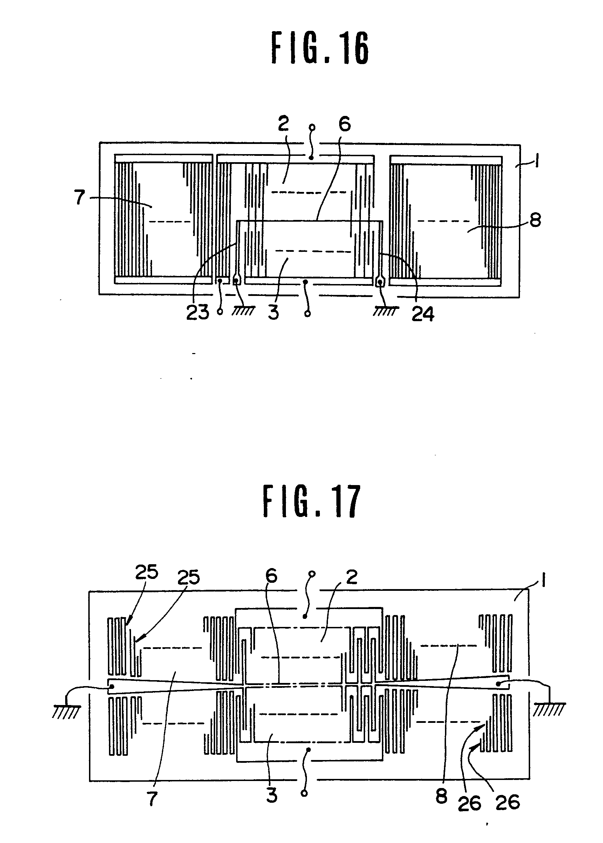

Referring to Fig. 15, there is shown another embodiment of the present invention, in which lead patterns 23 and 24 are provided between the IDTs 2 or 3 and the reflectors 7 and 8, one ends of the lead patterns 23 and 24 are connected to the common bus bar 6 and the other ends are guided to a peripheral edge of the piezo-electric substrate 1, and the lead patterns 23 and 24 are connected through the guided portions to lead terminals passed through a package of the filter in an electrically isolated manner therefrom.

In another embodiment of the invention shown in Fig. 16, bus bars other than the common bus bar 6 are connected to some or all of the gratings of the reflectors 7 or 8, whereby the connecting portions of the strips of the grating connected to lead terminals can be arranged along one side of the substrate 1 and the wire bonding process can be simplified, which results in the fact that the filter with a high reliability can be obtained.

Fig. 17 is another embodiment of the present invention. In this case, the common bus bar 6 for a relatively small number of electrode pairs of the IDTs 2 and 3 is extended across the reflectors 7 and 8 provided on the both sides of the IDTs 2 and 3 on the piezo-electric substrate 1, and the width of the common bus bar 6 is gradually increased toward the outer side ends of the reflectors 7 and 8. The reflectors 7 and 8 are formed by etching a number of mutually separated grooves 25, and 26 on the substrate 1.

With such a structure, when earthing wires are bonded to the widest end portions of the common bus bar 6, the other bus bar of IDTs can be connected to the lead terminals with ease. At the same time, the ohmic loss of the common bus bar 6 can be minimized and therefore the loss of the filter can be minimized.

It goes without saying that, if the reflectors 7 and 8 comprise each metal strips instead of the grooves 25 and 26, the filter can exhibit the similar effect.

**Claims**

1. A high frequency narrow-band double-mode filter comprising at least two resonators (2, 3) arranged adjacent to each other, acting as input and output transducers, each of said resonators (2, 3) having the same resonance frequency and comprising a pair of comb-type interdigital transducer electrode arrays (4, 5), the electrodes of said arrays being interleaved with each other, characterized in that a common bus bar (6) is provided between and connected to adjacent two of said resonators (2, 3), said two resonators (2, 3) being arranged in directions perpendicular to a propagation direction of waves excited by said resonators (2, 3) and in close proximity to each other on a piezoelectric substrate (1) so that acoustic coupling occurs between said adjacent two resonators (2, 3), thereby causing multiple resonance frequencies of different vibrating modes,

the overlap of the electrodes (2, 3) of said respective pairs of electrode arrays of said adjacent two resonators (2, 3) defining respective acoustic apertures of width w and the distance between said first and second acoustic apertures defining a gap g,

said filter utilizing said multiple resonance frequencies of different vibration modes generated by the acoustic coupling, wherein said width w and gap g satisfies the relation w≤20 λ and g≤6 λ, where λ is the wavelength of a wave corresponding to said same resonance frequency of each of said resonators.

2. A filter as set forth in claim 1, wherein a wave excited by said resonators (2, 3) is a surface skimming bulk wave (SSBW).

3. A filter as set forth in claim 1 or 2, wherein said two resonators (2, 3) form a unit section and a plurality of said unit sections are connected in a tandem manner so as to provide filter characteristics of a desired shape factor and relative attenuation.

4. A filter as set forth in claims 1 thru 3, wherein reflectors (11 thru 14) comprising a multiplicity of gratings made of metal strips are provided on both sides of said resonators to reflect waves corresponding to said double-mode vibrations occurred by said acoustic coupling.

5. A filter as set forth in claim 4, wherein said common bus bar (6) is formed integrally with and connected to at least one of the gratings of the reflectors, and said common bus bar is grounded through at least one grating such that the ohmic loss of said bus bar and the loss of said filter is reduced.

6. A filter as set forth in claims 1 thru 3, wherein reflectors (7, 8) comprising a multiplicity of gratings made of grooves (25, 26) in said substrate (1) are provided on both sides of said resonators to reflect waves corresponding to double-mode vibrations occurred by said acoustic coupling.

7. A filter as set forth in claim 6, wherein waves excited by said resonators (2, 3) include different types of waves other than a surface acoustic wave (SAW).

8. A filter as set forth in claim 1 or 6, wherein said common bus bar (6) is extended across the gratings of said reflectors and is not connected to the gratings, and the width of said common bus bar in the gratings is gradually increased toward the outer sides thereof.

9. A filter as set forth in claim 1 wherein said common bus bar is extended across the gratings of said reflectors and is connected to the gratings, and the width of said common bus bar in the gratings is gradually increased toward the outer sides thereof.

10. A filter as set forth in claim 1 wherein g is set to be below 3.

11. A filter as set forth in claim 1, wherein a wave excited by said resonators (2, 3) is a surface acoustic wave (SAW).

12. A filter as set forth in claim 1, wherein said common bus bar has a width on the order of g/2, and is connected to substantially all of said multiplicity of gratings.

13. A filter as set forth in claim 1, wherein said common bus bar has a width slightly less than twice the width of an individual interdigital transducer electrode.

14. A filter as set forth in claim 1, wherein said common bus bar is connected to substantially all of said multiplicity of gratings.

15. A filter as set forth in claim 1, wherein at least a pair of double mode filter sections (9, 10) formed in spaced parallel alignment on a surface of said single piezoelectric substrate (1),

the first electrode array of each resonator extending from and being electrically connected to said common bus bar,

a reflector at each end of said interdigitated transducer, each of said reflectors comprising a grating made of metal strips,

said common bus bar extending beyond both ends of said interdigitated transducers and being connected to substantially all of the metal strips of said reflectors, so that said transducers are grounded through said common bus bar and said reflectors,

said pair of double mode filter sections being separated by sufficient distance so that acoustic coupling therebetween does not take place,

a relatively wide interconnection bus, wider than the common bus bars (6) of the pair of filter sections, interconnecting the second electrode array of the first resonator of one of said filter sections to the second electrode array of the second resonator of the other filter section, thereby interconnecting an output of one filter section to an input of the other filter section, and

a relatively wide connection bus for the second electrode array of said second resonator of said one filter section and a like relatively broad connection bus for the second electrode array of said second resonator of the other filter section, these connection buses being broader than at least the common bus bars and being disposed to facilitate input and output connection to said tandem connected filter.

**Patentansprüche**

1. Hochfrequentes Doppelmodusfilter mit schmalem Durchlaßband, mit mindestens zwei nebeneinander angeordneten Resonatoren (2, 3), die als Eingangsund Ausgangswandler wirken, wobei jeder der Resonatoren (2, 3) die gleiche Resonanzfrequenz hat und zwei kammartige Wandlerelektrodenbereiche (4, 5) aufweist, deren Elektroden miteinander verschachtelt sind,

dadurch gekennzeichnet, daß

eine gemeinsame Bus-Schiene (6) zwischen zwei benachbarten Resonatoren (2, 3) angeordnet und mit diesen verbunden ist,

die beiden Resonatoren (2, 3) in senkrecht zur Ausbreitungsrichtung der von den Resonatoren (2, 3) erregten Wellen verlaufenden Richtungen und in enger Nähe zueinander so auf einem piezoelektrischen Substrat (1) angeordnet sind, daß zwischen den benachbarten zwei Resonatoren (2, 3) akustische Kopplung entsteht, wodurch Mehrfachresonanzfrequenzen verschiedener Schwingungsmodi verursacht werden,

die Überlappung der Elektroden (2, 3) der jeweiligen Paare von Elektrodenbereichen der benachbarten zwei Resonatoren (2, 3) jeweilige akustische Öffnungen mit der Breite w definiert und der Abstand zwischen den ersten und zweiten akustischen Öffnungen einen Spalt g definiert,

das Filter die von der akustischen Kopplung erzeugten Mehrfachresonanzfrequenzen mit den verschiedenen Schwingungsmodi benutzt und die Breite w und der Spalt g die Beziehung w ≤ 20λ und g ≤ 6λ erfüllen, wobei λ die Wellenlänge einer Welle ist, die der gleichen Resonanzfrequenz jedes des Resonatoren entspricht.

2. Filter nach Anspruch 1, bei dem eine von den Resonatoren (2, 3) erregte Welle eine oberflächenabtastende Massenwelle (SSBW) ist.

3. Filter nach Anspruch 1 oder 2, bei dem die zwei Resonatoren (2, 3) eine Einheits-Sektion bilden und mehrere der Einheits-Sektionen hintereinandergeschaltet sind, um Filtercharakteristiken mit gewünschtem Form-Faktor und relativer Dämpfung zu schaffen.

4. Filter nach Anspruch 1 bis 3, bei dem Reflektoren (11 bis 14) mehrere aus Metallstreifen gefertigte Gitterstäbe an beiden Seiten der Resonatoren aufweisen, um Wellen zu reflektieren, die den durch akustische Kopplung verursachten Doppelmodus-Schwingungen entsprechen.

5. Filter nach Anspruch 4, bei dem die gemeinsame Bus-Schiene (6) in mindestens einen der Gitterstäbe der Reflektoren integriert und mit diesem verbunden ist und die gemeinsame Bus-Schiene durch mindestens einen Gitterstab so geerdet ist, daß der Widerstandsverlust der Bus-Schiene und der Verlust des Filters reduziert werden.

6. Filter nach einem der Ansprüche 1 bis 3, bei dem Reflektoren (7, 8), die mehrere aus Nuten (25, 26) in dem Substrat (1) erzeugte Gitterstäbe aufweisen, an beiden Seiten der Resonatoren vorgesehen sind, um Wellen zu reflektieren, die durch akustische Kopplung verursachten Doppelmodus-Schwingungen entsprechen.

7. Filter nach Anspruch 6, bei dem die von den Resonatoren (2, 3) erregten Wellen verschiedene Wellentypen enthalten, die keine akustischen Oberflächenwelle (SAW) sind.

8. Filter nach Anspruch 1 oder 6, bei dem die gemeinsame Bus-Schiene (6) sich über die Gitterstäbe der Reflektoren erstreckt und nicht mit den Gitterstäben verbunden ist, und die Breite der gemeinsamen Bus-Schiene in den Gitterstäben zu deren äußeren Seiten hin allmählich zunimmt.

9. Filter nach Anspruch 1, bei dem die gemeinsame Bus-Schiene sich über die Gitterstäbe der Reflektoren erstreckt und mit den Gitterstäben verbunden ist, und die Breite der gemeinsamen Bus-Schiene in den Gitterstäben zu deren äußeren Seiten hin allmählich zunimmt.

10. Filter nach Anspruch 1, bei dem g kleiner als 3 eingestellt ist.

11. Filter nach Anspruch 1, bei dem eine von den Resonatoren (2, 3) erregten Welle eine akustische Oberflächenwelle (SAW) ist.

12. Filter nach Anspruch 1, bei dem die gemeinsame Bus-Schiene eine Breite in der Größenordnung von g/2 hat und mit im wesentlichen allen der vielen Gitterstäbe verbunden ist.

13. Filter nach Anspruch 1, bei dem die gemeinsame Bus-Schiene eine Breite hat, die geringfügig kleiner ist als die zweifache Breite einer einzelnen interdigitalen Wandlerelektrode.

14. Filter nach Anspruch 1, bei dem die gemeinsame Bus-Schiene mit im wesentlichen allen der vielen Gitterstäbe verbunden ist.

15. Filter nach Anspruch 1, bei dem mindestens zwei Doppelmodusfiltersektionen (9, 10) in beabstandeter paralleler Ausrichtung auf einer Oberfläche des einzigen piezoelektrischen Substrats (1) ausgebildet sind,

die erste Elektrodengruppe jedes Resonators von der gemeinsamen Bus-Schiene ausgeht und elektrisch mit dieser verbunden ist,

ein Reflektor an jedem Ende des interdigitalen Wandlers vorgesehen ist, wobei jeder der Reflektoren einen aus Metallstreifen gefertigten Gitterstab aufweist,

die gemeinsame Bus-Schiene sich über beide Enden der interdigitalen Wandler erstreckt und mit im wesentlichen allen Metallstreifen der Reflektoren verbunden ist, derart, daß die Wandler durch die gemeinsame Bus-Schiene und die Reflektoren geerdet sind,

die zwei Doppelmodusfiltersektionen durch einen hinreichenden Abstand so getrennt sind, daß keine akustische Kopplung zwischen ihnen stattfindet, ein verhältnismäßig breiter Zwischenverbindungsbus, der breiter ist als die gemeinsamen Bus-Schienen (6) der zwei Filtersektionen, die zweite Elektrodengruppe des ersten Resonators einer der Filtersektionen mit der zweiten Elektrodengruppe des zweiten Resonators der anderen Filtersektion verbindet, wodurch ein Ausgang einer Filtersektion mit einem Eingang der anderen Filtersektion verbunden ist, und

ein verhältnismäßig breiter Verbindungsbus für die zweite Elektrodengruppe des zweiten Resonators der einen Filtersektion und ein gleichartiger verhältnismäßig breiter Verbindungsbus für die zweite Elektrodengruppe des zweiten Resonators der anderen Filtersektion vorgesehen sind, wobei diese Verbindungsbusse zumindest breiter sind als die gemeinsamen Bus-Schienen und zum Erleichtern der Eingangs- und Ausgangsverbindung mit dem in Reihe geschalteten Filter vorgesehen sind.

**Revendications**

1. Filtre double-mode à bande étroite en hautes fréquences, comprenant au moins deux résonateurs (2, 3) disposés de manière adjacente l'un à l'autre et servant de transducteurs d'entrée et de sortie, chacun de ces résonateurs (2, 3) présentant une fréquence identique de résonance et comprenant une paire de groupes d'électrodes de transducteur (4, 5) du type en peigne et à imbrication, les électrodes de ces groupes étant imbriquées entre elles, caractérisé en ce que:

une barre bus commune (6) est prévue entre deux des résonateurs (2, 3) qui sont adjacents et elle est reliée à ces deux résonateurs,

ces deux résonateurs (2, 3) sont disposés sur un substrat piézoélectrique (1) à proximité étroite l'un de l'autre et suivant des directions perpendiculaires à une direction de propagation d'ondes excitées par ces résonateurs (2, 3), de sorte qu'il se produit un couplage acoustique entre ces deux résonateurs adjacents (2, 3), ce qui provoque ainsi des fréquences de résonance multiples de modes vibratoires différents,

le recouvrement des électrodes (2, 3) des paires respectives de groupes d'électrodes de ces deux résonateurs adjacents (2, 3) délimite des ouvertures acoustiques respectives de largeur w et la distance séparant les premières et les secondes ouvertures acoustiques définit un intervalle g,

.et le filtre utilise les fréquences de résonance multiples de modes vibratoires différents qui sont dues au couplage acoustique, la largeur w et l'intervalle g satisfaisant aux relations w ≤ 20λ et g ≤ 6λ, λ étant la longueur d'onde d'une onde correspondant à ladite fréquence identique de résonance de chacun des résonateurs.

2. Filtre suivant la revendication 1, dans lequel une onde excitée par lesdits résonateurs (2, 3) est une onde de volume rasant la surface (SSBW).

3. Filtre suivant la revendication 1 ou 2, dans lequel les deux résonateurs (2, 3) forment une section unitaire et plusieurs de ces sections unitaires sont reliées en tandem de façon à offrir des caractéristiques de filtrage présentant un facteur de forme et une atténuation relative souhaités.

4. Filtre suivant les revendications 1 à 3, dans lequel des réflecteurs (11 à 14), comportant de multiples réseaux formés de bandes métalliques, sont prévus sur l'un et l'autre des deux côtés des dits résonateurs de façon à réfléchir des ondes correspondant auxdites vibrations double-mode provoquées par le couplage acoustique.

5. Filtre suivant la revendication 4, dans lequel la barre bus commune (6) est reliée, en étant réalisée d'une pièce avec lui, à au moins l'un des réseaux des réflecteurs et cette barre bus commune est mise à la masse par l'intermédiaire d'au moins l'un des réseaux de façon que la perte ohmique de cette barre bus et la perte du filtre soient réduites.

6. Filtre suivant les revendications 1 à 3, dans lequel des réflecteurs (7, 8), comprenant de multiples réseaux formés de rainures (25, 26) ménagées dans le substrat (1), sont prévus sur l'une et l'autre des deux faces desdits résonateurs de façon à réfléchir des ondes correspondant à des vibrations double-mode provoquées par le couplage acoustique.

7. Filtre suivant la revendication 6, dans lequel des ondes excitées par les résonateurs (2, 3) comprennent différents types d'ondes autres qu'une onde acoustique de surface (SAW en anglais).

8. Filtre suivant la revendication 1 ou 6, dans lequel la barre bus commune (6) est disposée en travers de toute l'étendue des réseaux des réflecteurs et n'est pas reliée à ces réseaux et la largeur de cette barre bus commune dans les réseaux croît progressivement en direction de leurs côtés extérieurs.

9. Filtre suivant la revendication 1, dans lequel la barre bus commune est disposée en travers de toute l'étendue des réseaux des réflecteurs et est reliée à ces réseaux et la largeur de cette barre bus commune dans les réseaux croît progressivement en direction de leurs côtés extérieurs.

10. Filtre suivant la revendication 1, dans lequel g est fixé à une valeur inférieure à 3.

11. Filtre suivant la revendication 1, dans lequel une onde excitée par lesdits résonateurs (2, 3) est une onde acoustique de surface (SAW en anglais).

12. Filtre suivant la revendication 1, dans lequel la barre bus commune a une largeur de l'ordre de g/2 et est reliée à pratiquement la totalité des multiples réseaux.

13. Filtre suivant la revendication 1, dans lequel la barre bus commune a une largeur légèrement inférieure à deux fois la largeur d'une électrode individuelle de transducteur à imbrication.

14. Filtre suivant la revendication 1, dans lequel la barre bus commune est reliée à pratiquement la totalité des multiples réseaux.

15. Filtre suivant la revendication 1, dans lequel:

au moins deux sections de filtre double-mode (9, 10) sont formées suivant un alignement parallèle espacé sur une surface du substrat piézoélectrique unique (1),

le premier groupe d'électrodes de chaque résonateur s'étend à partir de la barre bus commune et est relié électriquement à celle-ci,

un réflecteur est prévu à chaque extrémité du transducteur à imbrication, chacun des réflecteurs comportant un réseau formé de bandes métalliques,

la barre bus commune s'étend au-delà de l'une et l'autre des deux extrémités des transducteurs à imbrication et est reliée à pratiquement la totalité des bandes métalliques des réflecteurs, de sorte que les transducteurs sont mis à la masse par l'intermédiaire de la barre bus commune et des réflecteurs,

les deux sections de filtre double-mode sont séparées par une distance suffisante pour qu'un couplage acoustique entre elles n'ait pas lieu,

un bus d'interconnexion relativement large, plus large que les barres bus communes (6) des deux sections de filtre, relie mutuellement le second groupe d'électrodes du premier résonateur de l'une des sections de filtre au second groupe d'électrodes du second résonateur de l'autre section de filtre, reliant ainsi mutuellement une sortie de la première section de filtre à une entrée de l'autre section de filtre, et

un bus de connexion relativement large est prévu pour le second groupe d'électrodes du second résonateur de la première section de filtre et un bus de connexion relativement large analogue est prévu pour le second groupe d'électrodes du second résonateur de l'autre section de filtre ces bus de connexion étant plus larges qu'au moins les barres bus communes et étant disposés de façon à faciliter la connexion d'entrée et de sortie sur le filtre à connexion tandem.

# FIG.1 (a)

# FIG.1 (b)

DISPLACEMENT

(s — MODE)

# FIG.1 (c)

DISPLACEMENT

(a — MODE)

# FIG.2

DISPLACEMENT

# FIG.3
## (a)

DISPLACEMENT

# FIG.3
## (b)

DISPLACEMENT

# FIG.4

# FIG.5

# FIG.6

Δf/f (x 10⁻⁴)

$\Delta f/f$ (x $10^{-4}$)

W/λ = 7

W/λ = 9

W/λ = 10

N = 500

h = 2.2% λ

f = 280 MHz

(g/λ)

# FIG.7

$\Delta f/f$ (x $10^{-4}$)

g/λ = 1.0

g/λ = 1.5

g/λ = 3.0

N = 500

h = 2.2% λ

f = 280 MHz

(W/λ)

EP 0 100 503 B1

# FIG.8

$\triangle$ f/f (x $10^{-4}$)

- N = 500
- h = 2.2% λ
- f = 280 MHz
- D = 2.2 x $10^{-2}$ $e^{-D}$

D = 0.3 W/λ + 0.7 g/λ

# FIG.9

| g \ w | 1 λ | 1.5 λ | 3 λ | 6 λ |
|---|---|---|---|---|
| 5 λ | ○ | ○ | ○ | △ |
| 10 λ | ○ | ○ | ○ | ✕ |
| 20 λ | △ | ✕ | ✕ | ✕ |

- N = 500
- h = 2.2% λ
- f = 280 MHz

○ COUPLING

△ VERY WEAK COUPLING

✕ NO COUPLING

4

# FIG. 10

# FIG. 11

# FIG. 12

# FIG. 13

# FIG. 14

# FIG. 15

# FIG. 16

# FIG. 17